# EUROPEAN PATENT SPECIFICATION

(11) **EP 1 728 254 B1**
(45) Date of publication and mention of the grant of the patent: **01.06.2011**
(21) Application number: 05708915.3
(22) Date of filing: 03.03.2005
(51) Int. Cl.: G11C 29/00

(54) **METHOD FOR DETECTING RESISTIVE BRIDGE DEFECTS IN THE GLOBAL DATA BUS OF SEMICONDUCTOR MEMORIES**
VERFAHREN ZUR ERKENNUNG RESISTIVER BRÜCKENDEFEKTE IN DEM GLOBALEN DATENBUS VON HALBLEITERSPEICHERN
PROCEDE DE DETECTION DE DEFAUTS D'UN PONT RESISTIF DANS LE BUS DE DONNEES UNIVERSEL DE MEMOIRES A SEMICONDUCTEURS

(30) Priority: 05.03.2004 US 550521 P; 30.07.2004 US 592844 P
(43) Date of publication of application: 06.12.2006
(73) Proprietor: NXP B.V., 5656 AG Eindhoven (NL)
(72) Inventor: AZIMANE, Mohamed, NL-5621 BA Eindhoven (NL); MAJHI, Ananta, NL-5621 BA Eindhoven (NL)
(74) Representative: Williamson, Paul Lewis
(86) International application number: PCT/IB2005/050778
(87) International publication number: WO 2005/088643

(56) References cited:
- EP-A- 0 449 417
- EP-A- 0 907 184
- VAN DE GOOR A J ET AL: "LOCATING BRIDGING FAULTS IN MEMORY ARRAYS" PROCEEDINGS OF THE INTERNATIONAL TEST CONFERENCE. NASHVILLE, OCT. 28 - 30, 1991, NEW YORK, IEEE, US, 15 May 1992 (1992-05-15), pages 685-694, XP000272306 ISBN: 0-8186-9156-5
- JUN ZHAO ET AL: "Maximal diagnosis of interconnects of random access memories" VLSI TEST SYMPOSIUM, 1999. PROCEEDINGS. 17TH IEEE DANA POINT, CA, USA 25-29 APRIL 1999, LOS ALAMITOS, CA, USA,IEEE COMPUT. SOC, US, 25 April 1999 (1999-04-25), pages 378-383, XP010334921 ISBN: 0-7695-0146-X

## Description

The invention relates to semiconductor testing. More particularly this invention relates to the generation of test patterns to detect bridge defects in the global read bus and global write bus in semiconductor memories organized in a Z-block configuration.

The electronics industry continues to rely upon advances in semiconductor technology to realize higher-function devices in more compact areas. For many applications, realizing higher-functioning devices requires integrating a large number of electronic devices into a single silicon wafer. As the number of electronic devices per given area of the silicon wafer increases, the manufacturing process becomes more difficult.

Many varieties of semiconductor devices have been manufactured having various applications in numerous disciplines. Such silicon-based semiconductor devices often include metal-oxide-semiconductor field-effect transistors (MOSFET), such as p-channel MOS (PMOS), n-channel MOS (NMOS) and complementary MOS (CMOS) transistors, bipolar transistors, BiCMOS transistors. Such MOSFET devices include an insulating material between a conductive gate and silicon-like substrate; therefore, these devices are generally referred to as IGFETs (insulated-gate FET).

Each of these semiconductor devices generally includes a semiconductor substrate on which a number of active devices are formed. The particular structure of a given active device can vary between device types. For example, in MOS transistors, an active device generally includes source and drain regions and a gate electrode that modulates current between the source and drain regions.

An important semiconductor device is memory. Obtaining cost-effective yield on memory devices is a continuing challenge. As devices approach dimensions in the fractions of microns, the probability of defects in the memory array increases. For example, as memories approach 1 MB and greater, in spite of best efforts to reduce sources of defects in the fabrication process, such as contamination, misalignment, process recipe tolerances, a number of devices will leave the fabrication process inoperable. Particularly challenging is connecting the memory cells in arrays via conductive lines. Resistive bridging may occur between the metal lines of the global read bus and global write bus.

Systematic and automatic testing of integrated circuits becomes increasingly important. With each new generation of integrated circuits component density, number of system functionalities, and clock speed are substantially increased. Integrated circuits have reached such complexity and speed that process defects are no longer detectable using even the most exhaustive and expensive conventional testing procedures. However, customers will not accept products that show their hidden defects in operational use, thereby rendering, for example, life support systems or aircraft control systems unreliable.

The paper 'Locating Bridging Faults in Memory Arrays' by A.J. van de Goor et al. in Proceedings of the International test Conference 1991, pages 685-694, discloses a memory array comprising a plurality of memory chips and a method according to the preamble of claim 1. A bridging fault is detected in the memory array by writing a value to a memory location, reading the value from the memory location, writing a complement of the value to a memory location, reading the complement of the value from the memory location and repeating these steps for all rows of the memory chips.

Modem architectures of low power and highly dense semiconductor memories are mainly based on multiple Z-blocks. Each Z-block is divided into different small subblocks that are controlled internally from within the Z-block. The row address decoder is divided into three blocks: the pre-decoder, the post-decoder, and the internal row decoder located internally within the Z-block. The internal row decoder selects the word line depending on the remainder of the address bits. A memory position is selected by activating a determined Z-block when a row decoder selects a specific row and the column decoder selects a specific column. The Z-blocks share the global read bus and the global write bus as an interface between the global inputs/outputs and the memory blocks.

In a particular architecture of memory arranged by Z-blocks, using Z-blocks increases the density of memory and the performance. Memories have an X and Y decoder that select the row and the column in a memory array. Then, a memory operation (read or write) can be performed. To increase the density of the memory, designers have included a third dimension to the memories by adding new address decoder, usually denoted as a "Z decoder". The user has an X, Y and Z decoder in the same integrated circuit.

To gain access to a memory position (in the memory array) the user first chooses the Z address to select which Z block is accessed, and of course, the X and Y location to select the row and the column in the selected Z block. Z-blocks are often called banks.

A conventional memory array is the special case in which Z=1, meaning a memory with having just one Z block. A memory array with multiple Z blocks (banks) is a memory with different blocks (or banks) where you have more storage. So, the memories organized per Z block are very dense. In a particular example memory, there may be up to 32 Z blocks on the same chip. Thus, 32 memory arrays share the same X-address and Y-address decoder

The family of march tests comprise consecutive read and write operations with a limited number of data backgrounds which are insufficient for detecting resistive bridges between the write and read data lines of the global data bus. Using multiple data backgrounds with the March tests is not feasible, because the complexity of the extended March tests depends on the number of bits per word and the memory size. For example, for a memory with B bits per word 2([log₂B]+1) data backgrounds are needed to cover all coupling possibilities between the write data lines and the read data lines of the global data bus. In fact, the data background needed for testing the global data bus is the same as the data background needed for detecting bridging faults between the memory cells that belong to a same word. However, in modem word-sliced memory architectures the bits belonging to a same word are not stored in a physically adjacent fashion. Various scrambling methods are used to distribute the memory cells for storing the bits of a same word through a row. Therefore, the likelihood of a bridging fault between memory cells for storing the bits of a same word is almost non-existent.

A substantial number of resistive bridges in the global data bus are not detected by the family of March tests, resulting in shipping of faulty products and causing reliability problems, because weak resistive bridges that have no fault effect on the memory behavior become stronger during use of the memory ultimately causing faulty behavior. However, combining the March tests with the data backgrounds needed to detect resistive bridges in the global data bus dramatically increases test complexity and test time.

There is a need to provide an improved method that is capable of covering substantially all possible locations for resistive bridge defects in the global data bus of a semiconductor memory. Furthermore, there is an additional need for detecting resistive bridge defects in the global data bus of a semiconductor memory that is capable of detecting weak resistive bridge defects.

The present invention is useful in testing for resistive bridge defects in the global data bus of a semiconductor memory. Such bridge defects may lie undetected in conventional testing.

In an example there is provided a method for detecting resistive bridge defects in a global data bus of a semiconductor memory having N Z-blocks. The method comprises providing first a plurality of data sets according to a predetermined test pattern suitable for detecting the resistive bridge defects. Second, using the plurality of data sets, write and read operations are performed to at least a predetermined memory position within a Z-block of the N Z-blocks of the semiconductor memory such that each data set is applied to each of the at least a predetermined memory position. For a plurality of the N Z-blocks of the semiconductor memory, the first two steps are repeated.

In an example embodiment according to the present invention there is provided a method for detecting resistive bridge defects in a global data bus of a semiconductor memory having N Z-blocks. The method comprises providing first a plurality of data sets according to a predetermined test pattern for detecting the resistive bridge defects. Using the plurality of data sets, write and read operations are performed to at least a predetermined memory position within a Z-block of the N Z-blocks of the semiconductor memory such that each data set is applied to each of the at least a predetermined memory position. Third, The first two steps are repeated. Having repeated the first two steps, for a plurality of the N Z-blocks of the semiconductor memory, the first three steps are repeated.

In yet another example there is provided a method for detecting resistive bridge defects in a global data bus of a read-only semiconductor memory having N Z-blocks. The method comprises, determining a plurality of data sets according to a predetermined test pattern for detecting the resistive bridge defects. Corresponding to the determined plurality of data sets out of at least a predetermined memory position within a Z-block of the N Z-blocks of the semiconductor memory, data are read. For a plurality ofN Z-blocks of the read-only semiconductor memory, the previous steps are repeated.

The above summaries of the present invention are not intended to represent each disclosed embodiment, or every aspect, of the present invention. Other aspects and example embodiments are provided in the figures and the detailed description that follows.

The invention may be more completely understood in consideration of the following detailed description of various embodiments of the invention in connection with the accompanying drawings, in which:
FIG. 1 is a simplified block diagram schematically illustrating a Z-block architecture of a semiconductor memory; and,
FIG. 2 is a simplified block diagram of a Z-block schematically illustrating memory positions used in a method for detecting bridge defects according to the invention; and FIG. 3 is a flowchart of an example embodiment according to the present invention.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the scope of the invention as defmed by the appended claims.

The present invention has been found to be useful in overcoming challenges in testing of resistive defects in semiconductor memory. Using multiple data backgrounds with the March tests for detecting resistive bridge defects in the global data bus of a semiconductor memory substantially increases test complexity and test time. For a memory with B bits per word 2([log₂B]+1) data backgrounds are needed to cover all coupling possibilities between the write data lines and the read data lines of the global data bus. Table 1 shows the data background needed for covering all bridging possibilities for a memory organized by eight bits per word.

| Normal |
|---|
| 00000000 |
| 11111111 |
| 01010101 |
| 10101010 |
| 00110011 |
| 11001100 |
| 00001111 |
| 11110000 |
| Table 1 |

As is evident to one of skilled in the art, this solution substantially increases the test complexity as well as the test time, in particular for modem semiconductor memories having a high number of bits per word and big memory sizes.

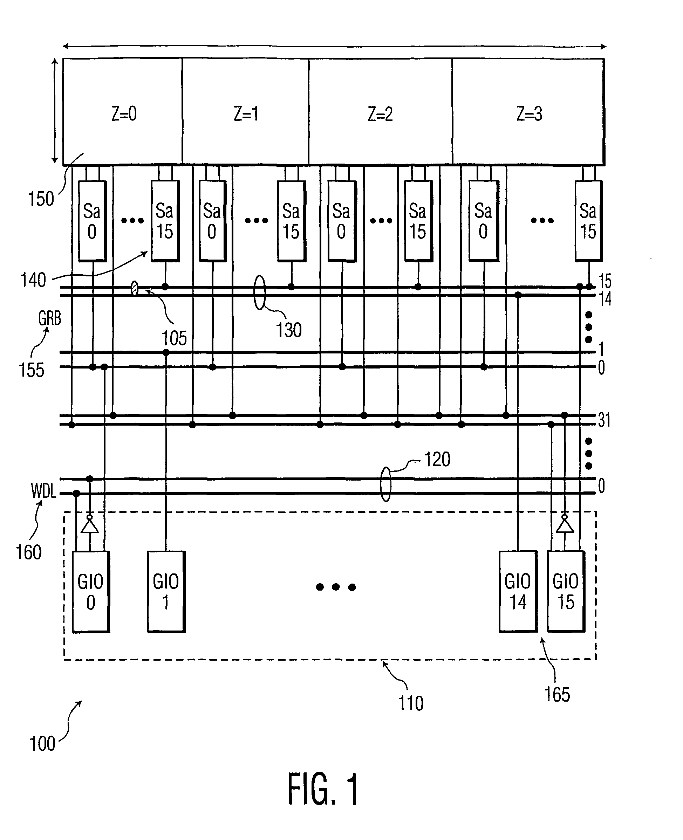

FIG. 1 schematically illustrates a memory 100 with 4 Z-blocks (150) and 1024 columns of one bit. Each Z-block has its own sense amplifier 140 but is sharing the global read bus 155 and the global write bus 160. A modem semiconductor memory contains 32 or more Z-blocks. For example, a memory with 8 column-slice, 128 bits per word and 32 Z-blocks contains 32768 columns of one bit. The columns are distributed from the left to the right of a memory chip and cover most of the memory area. Therefore, the global read bus and the global write bus are disposed below the Z-blocks and extend from the left of a chip to the right. Thus, the likelihood of having a bridge defect, known as critical area, between the read data lines and between the write data lines of the global data bus is very high due to the length of the data lines and the limited space between adjacent data lines. FIG. 1 shows a bridge defect 105 in the global read bus (grb) 155 between (130) the read data lines R[15] and R[14]. This defect is not detected by the march test when the data backgrounds 00000000 and 11111111 are used, because the read and write data lines of the global data bus drive the same bits (0 or 1) for neighboring lines. This bridge is detected if the pattern 01010101 1 or 10101010 is used as the data background. However, if the neighboring read and write data lines do not belong to the same physical lines, the defect is not detected using the above test patterns. For example, if the read data line R[i] becomes the neighbor of R[i+2] and R[i-2] instead of R[i+1] and R[i-1], while the write data line W[i] becomes the neighbor of W[i+2] and W[i-2] instead of W[i+1] and W[i-1], the bridge is not detected. In this case, the test pattern 00110011 or 11001100 is capable of detecting the bridge. To cover all possible scrambling of the read and write data lines 160, the various data backgrounds, as shown in Table 1 for eight bits per word, have to be used. However, applying these data backgrounds on unique memory positions is not sufficient due to the physical distribution of the global inputs/outputs through the global read bus and the global write bus and the physical location of the Z-blocks. When a resistive bridge 105 is located near the Z-block 0, as shown in FIG. 1, the resistive bridge is not detected with the above data backgrounds if they are written and read out of the third Z-block due to the physical location of the fifteenth global inputs/outputs, which is located near the third Z-block, relatively far away from the physical location of the defect. The resistive bridge shown in FIG. 1 is located between (165) the read data lines R[15] and R[14] or between R[15] and R[13] in case of scrambling. The defect is not detected even when the test patterns 01010101 and 00110011 are used at the third Z-block. The read-out data are transmitted correctly from the third Z-block to the global outputs. Depending on the location and the size, the defect only disturbs the carried signal but does not change the logical behavior of the data. Therefore, the defect is not detected. Similarly, a defect located between R[0] and R[1] or between R[0] and R[2] in case of scrambling is detected if the correct test patterns are used at the Z-block 0. The test escape described above depends on numerous parameters: the number of Z-blocks, the length of the data lines, the defect location, the defect size and the physical location of the global inputs/outputs which are shared by the Z-blocks and are not equally distributed. Such test escapes are only avoided by applying the correct test patterns to all Z-blocks, substantially increasing test complexity and test time.

The above problems are overcome by the method for detecting resistive bridge defects in the global data bus of semiconductor memories according to the invention, which is described in the following. In an example embodiment according to the invention the corresponding data backgrounds, as outlined in Table 1 for the example of 8 bits per word, are applied to each Z-block of a semiconductor memory to be tested, but not at all possible memory positions. By applying the data backgrounds to all Z-blocks substantially all possible physical locations for resistive bridges in the global data bus are covered. Selection of specific memory addresses at each Z-block is sufficient to cover substantially all possible physical locations for resistive bridges in the global data bus while substantially decreasing test complexity. Therefore, substantially all data paths, read and write, between global memory inputs, all the Z-blocks, and global memory outputs are tested. In an example embodiment, the same data backgrounds are repeatedly applied at each bit column for all Z-blocks. Repeatedly applying the same data backgrounds, for example four or more times, sensitizes weak defects and, therefore, enables detection of weak resistive bridges not only in the global read bus and the global write bus, but also at bit lines and sense amplifiers. The data backgrounds are applied at least at one memory position at all Z-blocks. Usually, the highest memory position enables detection of resistive bridge defects at the bit lines and sense amplifiers.

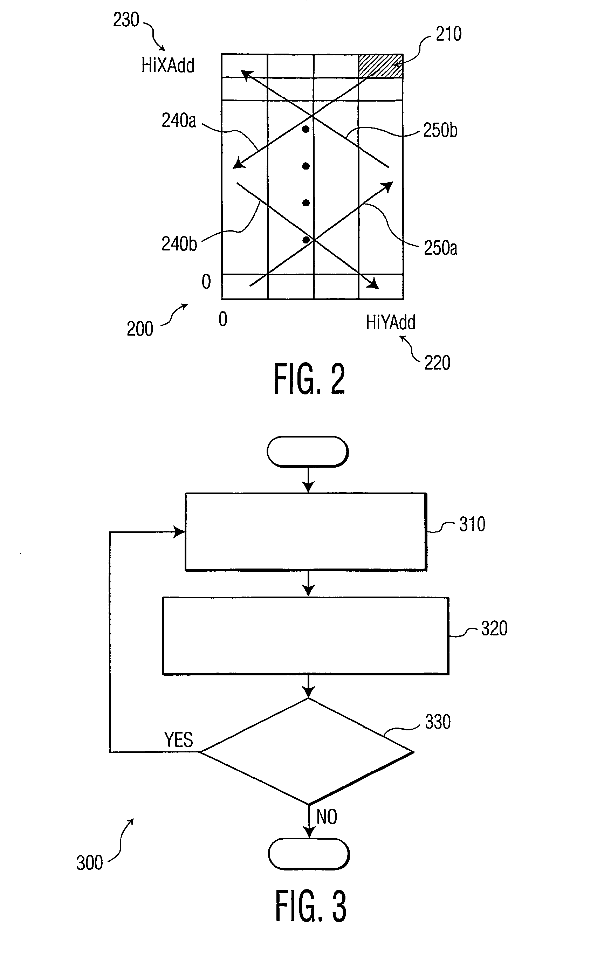

However, in another embodiment, in order to be able to detect all possible defects all bit columns are tested for all Z-blocks for at least four times, as shown in FIG. 2. As shown in FIG. 2, the above data backgrounds are applied to all bit columns and a predetermined portion of rows, for example, in a diagonal fashion in the case of one Z-block. Data backgrounds 200 are applied to the example memory as outlined in Table 1. All of the of the bit columns are tested four times with the aforementioned data backgrounds. The memory matrix is divided into two Xs, an upper X one at 240a, 250b and a lower X at 240b, and 250b. The data backgrounds 200 are applied in a selective diagonal way from a starting most significant memory position 210 proceeding via path 240a and 240b in a first direction. From the least significant memory position (0,0), the data backgrounds 200 proceed via the path 250a and 250b.

In an example embodiment of the method for detecting resistive bridge defects in the global data bus of a semiconductor memory having N Z-blocks according to the invention the following steps are performed. A plurality of data sets according to a predetermined test pattern, such as the one shown in Table 1, for detecting the resistive bridge defects are provided. For example, the data sets are predetermined and hard coded in a test circuitry of the semiconductor memory. During testing, the plurality of data sets are used to perform write and read operations to at least a predetermined memory position within a Z-block of the N Z-blocks such that each data set is applied to each of the at least a predetermined memory position. The number of predetermined memory positions, determined such that substantially all possible bridge defect locations are covered, is considerably less than the number of all possible memory positions, substantially reducing test complexity and test time. Preferably, the at least a predetermined memory position comprises the highest memory position in order to enable detection of resistive bridge defects at bit lines and sense amplifiers. Further preferably, the at least a predetermined memory position comprises all bit columns of the Z-block and a predetermined portion of rows of the Z-block in order to cover substantially all possible bridge defect locations. For example, the predetermined memory locations are determined such that they are arranged in a diagonal fashion. In order to sensitize weak bridge defects, the write and read operations of the same data sets to the same memory locations are repeated consecutively for at least four times. These steps are then repeated for all Z-blocks of the semiconductor memory.

In case of Read-Only Memories (ROMs) organized in Z-blocks, the global write bus does not exist. However, in order to detect resistive bridges in the global read bus the same data background as discussed above is applied. Since the memory content of the ROM can not be changed because it is hard coded, the global read bus is tested by reading a memory content that is comparable to the data backgrounds discussed above. For example, a set of consecutive read operations is combined to obtain the data backgrounds. Suppose that the pattern 01010101 described in Table 1 is not hard coded in the ROM. A combination of adjacent bits of 01 and 10 from different memory positions is then read out to test the global read bus. It has the same effect for detecting resistive bridges as reading the original pattern 01010101 from one memory position. For example, four different memory positions contain the patterns 0111_1111, 1101_0000, 1101_1111, and 1111_0100. Thus, it is possible to substitute reading of the test pattern 01010101 by reading the above four patterns. The same applies for the other test patterns. In case of multiple port SRAMs organized by Z-blocks, it is sufficient to test the global read bus and the global write bus from one memory port where read and write operations are enabled.

The method for detecting resistive bridge defects in the global data bus of a semiconductor memory having N Z-blocks according to the invention provides a test procedure for detecting resistive bridge defects in the global data bus of a semiconductor memory that is capable of covering a significant majority and/or substantially all possible locations for bridge defects as well as being capable of detecting weak bridge defects, while substantially reducing test complexity and test time.

FIG. 3 depicts a flowchart of an embodiment 300 of the present invention. The user defines and provides a predetermined test pattern 310 for detecting resistive bridge defects. He performs write and read operations to predetermined memory positions within a Z-block 320. If there are additional Z-blocks to test 330, the previous operations (310, 320) are repeated. The predetermined test patterns would be dictated by processing experience and historical data applicable to the particular semiconductor memory tested.

While the present invention has been described with reference to several particular example embodiments, those skilled in the art will recognize that many changes may be made thereto without departing from the scope of the present invention, which is set forth in the following claims.

## Claims

1. A method for detecting resistive bridge defects (105) in a global data bus (155) of a semiconductor memory having N Z-blocks (150) comprising:
a) providing a plurality of data sets according to a predetermined test pattern for detecting the resistive bridge defects (105); and
b) using the plurality of data sets, performing write and read operations to at least a predetermined memory position within a Z-block of the N Z-blocks (150) of the semiconductor memory such that each data set is applied to each of the at least a predetermined memory position;
said method being **characterized by**:
c) repeating the steps a) and b) with the same plurality of data sets and the same at least a predetermined memory position; and,
d) repeating the steps a) to c) for a plurality of the N Z-blocks (150) of the semiconductor memory.

2. A method as defined in claim 1, wherein the at least a predetermined memory position is less than all memory positions of the Z-block (150).

3. A method as defined in claim 2, wherein the plurality of the N Z-blocks (150) comprises the N Z-blocks (150) of the semiconductor memory.

4. A method as defined in claim 3, wherein the at least a predetermined memory position comprises all bit columns of the Z-block (150) and a predetermined portion of rows of the Z-block (150).

5. A method as defined in claim 4, wherein the memory positions are determined in a diagonal fashion (200).

6. A method as defined in claim 5, wherein the steps a) and b) are repeated at least four times.

7. A method as defined in claim 6, wherein the at least a predetermined memory position comprises the highest memory position.

## Patentansprüche

1. Verfahren zum Detektieren von resistiven Brückendefekten (105) in einem globalen Datenbus (155) eines Halbleiterspeichers mit N Z-Blöcken (150) enthaltend:
a) Bereitstellen einer Vielzahl von Datensätzen gemäß einem vorbestimmten Testmuster zum Detektieren der resistiven Brückendefekte (105); und
b) unter Verwendung der Vielzahl von Datensätzen, Durchführen von Schreibeund Leseoperationen auf mindestens einer vorbestimmten Speicherposition eines Z-Blocks der N Z-Blöcke (150) des Halbleiterspeichers, so dass jeder Datensatz auf jede der mindestens einen vorbestimmten Speicherposition angewendet wird;
wobei das Verfahren **gekennzeichnet ist durch**:
c) Wiederholen der Schritte a) und b) mit derselben Vielzahl von Datensätzen und derselben mindestens einen vorbestimmten Speicherposition; und
d) Wiederholen der Schritte a) bis c) für eine Vielzahl der N Z-Blöcke (150) des Halbleiterspeichers.

2. Verfahren wie in Anspruch 1 definiert, wobei die mindestens eine vorbestimmte Speicherposition niedriger ist als alle Speicherpositionen des Z-Blocks (150).

3. Verfahren wie in Anspruch 2 definiert, wobei die Vielzahl der N Z-Blöcke (150) die N Z-Blöcke (150) des Halbleiterspeichers aufweist.

4. Verfahren wie in Anspruch 3 definiert, wobei die mindestens eine vorbestimmte Speicherposition alle Bitspalten des Z-Blocks (150) und einen vorbestimmten Teil an Zeilen des Z-Blocks (150) aufweist.

5. Verfahren wie in Anspruch 4 definiert, wobei die Speicherpositionen in einer diagonalen Weise (200) bestimmt werden.

6. Verfahren wie in Anspruch 5 definiert, wobei die Schritte a) und b) mindestens vier Mal wiederholt werden.

7. Verfahren wie in Anspruch 6 definiert, wobei die mindestens eine vorbestimmte Speicherposition die höchste Speicherposition enthält.

## Revendications

1. Procédé de détection de défauts d'un pont résistif (105) dans un bus de données universel (155) d'une mémoire à semi-conducteurs ayant N blocs Z (150) comprenant les étapes suivantes :
a) fournir une pluralité d'ensembles de données selon une séquence de test prédéterminée pour détecter les défauts du pont résistif (105) ; et
b) en utilisant la pluralité d'ensembles de données, effectuer des opérations d'écriture et de lecture au niveau d'au moins une position de mémoire prédéterminée à l'intérieur d'un bloc Z des N blocs Z (150) de la mémoire à semi-conducteurs de sorte que chaque ensemble de données soit appliqué à chacune des au moins une position de mémoire prédéterminée ;
ledit procédé étant **caractérisé par** les étapes suivantes :
c) répéter les étapes a) et b) avec la même pluralité d'ensembles de données et la même au moins une position de mémoire prédéterminée ; et
d) répéter les étapes a) à c) pour une pluralité de N blocs Z (150) de la mémoire à semi-conducteurs.

2. Procédé selon la revendication 1, dans lequel l'au moins une position de mémoire prédéterminée est moins que toutes les positions de mémoire du bloc Z (150).

3. Procédé selon la revendication 2, dans lequel la pluralité de N blocs Z (150) comprend les N blocs Z (150) de la mémoire à semi-conducteurs.

4. Procédé selon la revendication 3, dans lequel l'au moins une position de mémoire prédéterminée comprend toutes les colonnes de bits du bloc Z (150) et une partie prédéterminée de rangées du bloc Z (150).

5. Procédé selon la revendication 4, dans lequel les positions de mémoire sont déterminées de façon diagonale (200).

6. Procédé selon la revendication 5, dans lequel les étapes a) et b) sont répétées au moins quatre fois.

7. Procédé selon la revendication 6, dans lequel l'au moins une position de mémoire prédéterminée comprend la plus haute position de mémoire.
